# EUROPÄISCHE PATENTANMELDUNG

(11) **EP 3 002 778 A1**
(43) Veröffentlichungstag der Anmeldung: **06.04.2016**
(21) Anmeldenummer: 14187533.6
(22) Anmeldetag: 02.10.2014
(51) Int. Cl.: H01L 21/28, G11C 16/04, H01L 29/423, H01L 29/788, H01L 29/66

(54) **Flash-Speicherzelle und Verfahren zu ihrer Herstellung**

(71) Anmelder: Elmos Semiconductor Aktiengesellschaft, 44227 Dortmund (DE)
(72) Erfinder: Kleining, Tobias, 44227 Dortmund (DE); Vaitkevitch, Sergej, 44227 Dortmund (DE); Hofmann, Martin, 44227 Dortmund (DE)
(74) Vertreter: von Kreisler Selting Werner - Partnerschaft von Patentanwälten und Rechtsanwälten mbB

(57) **Zusammenfassung**

Die Flash-Speicherzelle, die durch Anlegen von Programmier- und Löschspannungen beschreibbar sowie löschbar und durch Anlegen einer Lesespannung auslesbar ist, ist verstehen mit einem Halbleitersubstrat (16), in dessen Oberseite (22) voneinander beabstandete Drain- und Source-Anschlussgebiete (24,26) eingebracht sind. Ferner weist die Flash-Speicherzelle eine Gate-Isolationsschicht auf. Die Flash-Speicherzelle ist ferner mit einem Speicherelement (34) für elektrische Ladung versehen. Das Speicherelement (34) ist dezentral zwischen den Drain- und Source-Anschlussgebieten (24,26) und mit jeweiligem lateralen Abstand zu beiden positioniert. Die Flash-Speicherzelle weist eine die Gate-Isolationsschicht (30) überdeckende, das Speicherelement (34) allseitig umgebende sowie gegenüber diesem durch ein Dielektrikum (44,48) elektrisch isolierte Steuertransistor-Gate-Elektrode (32) zur Erzeugung eines wahlweise elektrisch leitenden oder sperrenden Kanals unterhalb der Steuertransistor-Gate-Elektrode (32) auf, wobei die Oberseite (22) des Halbleitersubstrats (16) unterhalb der Gate-Isolationsschicht (30) in einem Bereich zwischen dem Drain- und dem Source-Anschlussgebiet (24,26) ein laterales Dotierstoffprofil aufweist, das im Bereich unterhalb des Speicherelements (34) zur Einstellung einer relativ hohen ersten Schwellspannung einen Dotierstoff von einem ersten Leitungstyp und im Bereich unterhalb der Steuertransistor-Gate-Elektrode (32) zur Einstellung einer im Vergleich zur ersten Schwellspannung wesentlich geringeren zweiten Schwellspannung den ersten Dotierstoff (52) und einen zweiten Kompensationsdotierstoff (56) von einem zum ersten Leitungstyp entgegengesetzten zweiten Leitungstyp aufweist.

## Beschreibung

Die Erfindung betrifft eine Flash-Speicherzelle sowie ein Verfahren zur Herstellung einer solchen Flash-Speicherzelle.

Flash-Speicherzellen zur Speicherung eines oder mehrerer Bits sind grundsätzlich bekannt. Sie verfügen im Regelfall über ein Floating-Gate, das die binäre Information bzw. die binären Informationen speichert (nachfolgend auch Speicherelement genannt), und das kapazitiv an ein Steuer-Gate gekoppelt ist. Beide Gates sind durch jeweils eine Gate-Isolationsschicht ggf. unterschiedlicher Dicke gegenüber dem Kanalgebiet eines Halbleitersubstrats, das zwischen einem Drain- und einem Source-Anschlussgebiet angeordnet ist, isoliert. Durch Ausnutzung des Tunneleffekts lässt sich nun Ladung in das Speicherelement einbringen bzw. auch wieder entnehmen. Je nach Ladungszustand speichert das Speicherelement eine von mindestens zwei binären Informationen.

Eine bekannte Flash-Speicherzelle ist in US-A-2013/0099301 beschrieben.

Wünschenswert bei Flash-Speicherzellen ist es, dass die gespeicherte binäre Information möglichst lange und insbesondere auch bei erhöhten Umgebungstemperaturen gespeichert bleibt. Ferner sollten diejenigen Flash-Speicherzellen einer Bitleitung, deren binäre Information durch Sperren des Stromflusses durch die Zelle (bei angelegter Lesespannung am Steuer-Gate) repräsentiert ist, auch zuverlässig sperren. Beides sollte über einen erweiterten bzw. erhöhten Temperaturbereich von bspw. über 125°C und bis zu 170°C gewährleistet sein.

Aufgabe der Erfindung ist es, eine Flash-Speicherzelle anzugeben, bei der die binäre Information auch bei erhöhten Temperaturen über einen ausreichend langen Zeitraum korrekt gespeichert und korrekt auslesbar bleibt. Ferner ist es Aufgabe der Erfindung, ein Verfahren zur Herstellung einer derartigen Flash-Speicherzelle anzugeben.

Zur Lösung der erstgenannten Aufgabe wird mit der Erfindung eine Flash-Speicherzelle, die durch Anlegen von Programmier- und Löschspannungen beschreibbar sowie löschbar und durch Anlegen einer Lesespannung auslesbar ist, vorgeschlagen, wobei die Flash-Speicherzelle versehen ist mit
- einem Halbleitersubstrat, das eine Oberseite aufweist,
- in die Oberseite des Halbleitersubstrats eingebrachten, voneinander beabstandeten Drain- und Source-Anschlussgebieten,
- einer Gate-Isolationsschicht, die auf der Oberseite des Halbleitersubstrats zwischen dem Drain- und dem Source-Anschlussgebiet angeordnet ist,
- einem von der Gate-Isolationsschicht aufragenden Speicherelement aus einem Speichermaterial für elektrische Ladung, die durch Erzeugen eines Tunnelstroms durch den unterhalb des Speicherelements angeordneten Bereich der Gate-Isolationsschicht hindurch elektrisch auf- und entladbar ist,
- wobei das Speicherelement dezentral zwischen den Drain- und Source-Anschlussgebieten und mit jeweiligem lateralen Abstand zu beiden positioniert ist, und
- einer die Gate-Isolationsschicht überdeckenden, das Speicherelement allseitig umgebenden sowie gegenüber diesem durch ein Dielektrikum elektrisch isolierten Steuertransistor-Gate-Elektrode zur Erzeugung eines wahlweise elektrisch leitenden oder sperrenden Kanals unterhalb der Steuertransistor-Gate-Elektrode,
- wobei die Oberseite des Halbleitersubstrats unterhalb der Gate-Isolationsschicht in einem Bereich zwischen dem Drain- und dem Source-Anschlussgebiet ein laterales (d.h. zwischen Drain- und Source-Anschlussgebiet) Dotierstoffprofil aufweist, das im Bereich unterhalb des Speicherelements zur Einstellung einer relativ hohen ersten Schwellspannung einen Dotierstoff von einem ersten Leitungstyp und im Bereich unterhalb der Steuertransistor-Gate-Elektrode (und damit außerhalb des Bereichs unterhalb des Speicherelements) zur Einstellung einer im Vergleich zur ersten Schwellspannung wesentlich geringeren zweiten Schwellspannung den ersten Dotierstoff und einen zweiten Kompensationsdotierstoff von einem zum ersten Leitungstyp entgegengesetzten zweiten Leitungstyp aufweist.

Erfindungsgemäß lässt sich eine derartige Flash-Zelle gemäß einem Verfahren herstellen, bei dem
- ein Halbleitersubstrat mit einer Oberseite bereitgestellt wird, in die ein Drain- und ein Source-Anschlussgebiet eingebracht sind und auf der in einem dezentral und im Abstand zu den Drain- und Source-Gebieten gelegenen Teilbereich zwischen dem Drain- und dem Source-Anschlussgebiet eine erste Gate-Isolationsschicht aufgebracht ist, von der ein Speicherelement aus Speichermaterial für elektrische Ladung aufragt,
- im spitzen Winkel von einer Seite oder allseitig des Speicherelements aus in die Oberfläche des Halbleitersubstrats und damit auch schräg unterhalb des Speicherelements erste Ionen zum örtlichen Dotieren des Halbleitersubstrats mit einem ersten Dotierstoff eines ersten Leitungstyps zwecks Einstellung einer relativ hohen ersten Schwellspannung im Bereich unter dem Speicherelement implantiert werden,
- in den Bereich der Oberfläche des Halbleitersubstrats zwischen den Drain- und Source-Anschlussgebieten sowie außerhalb des Speicherelements zur Kompensation der dort implantierten ersten Ionen zweite Ionen zur örtlichen Kompensationsdotierung mit einem zweiten Dotierstoff von einem dem ersten Leitungstyp entgegengesetzten zweiten Leitungstyp zwecks Einstellen einer gegenüber der ersten Schwellspannung wesentlich geringeren zweiten Schwellspannung im Bereich außerhalb des Speicherelements implantiert werden und
- eine zweite Gate-Isolationsschicht lateral zur ersten Gate-Isolationsschicht auf der Oberseite des Halbleitersubstrats zwischen den Drain- und Source-Anschlussgebieten mit einer das Speicherelement allseitig umgebenden und gegebenenfalls dieses überdeckenden Steuertransistor-Gate-Elektrode ausgebildet wird.

Die erfindungsgemäße Flash-Speicherzelle ist als Floating-Gate-Transistor ausgebildet, der ein Steuer-Gate und ein Floating-Gate aufweist, die, wie bei Floating-Gate-Transistoren an sich üblich, kapazitiv gekoppelt sind. Die Flash-Speicherzelle weist ein Transistor-Kanalgebiet auf, das in der Oberseite eines Halbleitersubstrats und in diesem ausgebildet ist. Über dem Kanalgebiet befindet sich eine Gate-Isolationsschicht, auf der das Speicherelement aus einem Speichermaterial für elektrische Ladung angeordnet ist, die durch Erzeugen eines Tunnelstroms durch den unterhalb des Speicherelements angeordneten Bereich der Gate-Isolationsschicht hindurch elektrisch aufladbar und elektrisch entladbar ist. Bei dem Speichermaterial des Speicherelements (Floating-Gate) handelt es sich beispielsweise um Polysilizium.

Das von der Gate-Isolationsschicht aufragende Speicherelement ist allseitig und auf seiner Oberseite durch ein Dielektrikum überdeckt.

Erfindungsgemäß ist nun dieses Speicherelement (Floating-Gate) außermittig, d.h. dezentral, zwischen den Drain- und Source-Anschlussgebieten angeordnet. Die Bereiche um das Speicherelement herum und insbesondere zwischen dem Speicherelement und dem Drain-Anschlussgebiet einerseits sowie dem Speicherelement und dem Source-Anschlussgebiet andererseits sind von einer Steuertransistor-Gate-Elektrode überdeckt, die das eigentliche Steuer-Gate des Floating-Gate-Transistors bildet und mit der das Floating-Gate kapazitiv gekoppelt ist.

Die Besonderheit der erfindungsgemäßen Flash-Speicherzelle besteht darin, dass sie ein laterales Oberflächen- sowie oberflächennahes Dotierstoffprofil aufweist, um unterhalb des Speicherelements (Floating-Gate) eine wesentlich höhere Schwellspannung einzustellen als unterhalb des Steuer-Gates. Hintergrund dieser Maßnahme ist, dass die Schwellspannung des Floating-Gates einer Flash-Speicherzelle durch den jeweiligen Ladungszustand des Floating-Gates bestimmt ist. Als "neutraler Zustand" des Floating-Gates wird dabei diejenige Schwellspannung verstanden, bei der dem Floating-Gate weder die eine binäre Information (beispielsweise binär EINS) noch die andere binäre Information (beispielsweise binär NULL) zugeordnet werden kann. Gelingt es nun, den Auslesearbeitspunkt, d. h. die an das Steuer-Gate anzulegende Auslesespannung möglichst zentral zwischen die Schwellspannungswerte für den einen binären Zustand und den anderen binären Zustand zu legen, so können die beiden binären Zustände (beispielsweise binär EINS und binär NULL) durch Aufbringen entsprechend vergleichsweise geringer Ladungen immer noch unterschieden werden. Da aber die Kurve der elektrischen Entladung von Floating-Gates über die Zeit exponentiell abnimmt, liegt der erfindungsgemäße Floating-Gate-Transistor, was seine Ladung betrifft, wegen deren vergleichsweise geringen Höhe im weniger stark abklingenden Bereich der exponentiellen Entladungsfunktion. Das bedeutet, dass über einen längeren Zeitraum sich die Entladungscharakteristik des Floating-Gate-Transistors nur gering ändert und damit die gespeicherte Information über einen wesentlich längeren Zeitraum gehalten werden kann als dies der Fall ist, wenn zur sicheren Unterscheidung der beiden binären Zustände vergleichsweise viel Ladung in das Floating-Gate eingebracht werden muss.

Um nun die Leckströme auch bei vergleichsweise hohen Temperaturen von bis zu 170°C und darüber vergleichsweise gering zu halten, ist erfindungsgemäß vorgesehen, dass die Kanallänge unter dem Steuer-Gate durch die dezentrale Anordnung des Speicherelements größer ist als bei zentraler Anordnung des Speicherelements zwischen den Drain- und Source-Anschlussgebieten. Dadurch sind die Leckströme, die durch den Kurzkanaleffekt verursacht werden, auf einen für diesen zu höheren Temperaturen erweiterten Temperaturbereich auf einen (noch) vertretbaren Rahmen reduziert.

Insgesamt ergibt sich damit unter Verwendung des erfindungsgemäßen Flash-Zellen-Aufbaus eine verbesserte Konstruktion, und zwar dergestalt, dass die gespeicherte binäre Information auch bei erhöhten Temperaturen für längere Zeit gehalten und korrekt ausgelesen werden kann.

Das laterale Dotierstoffprofil auf der Oberseite des Halbleitersubstrats und im oberseitennahen Bereich des Halbleitersubstrats, also im Kanalgebiet zwischen den Drain- und Source-Anschlussgebieten, wird durch eine Doppelimplantation von Dotierstoffen jeweils unterschiedlichen Leitungstyps erzielt. Zunächst wird durch eine Schrägimplantation, ggf. in mehreren Implantationsschritten bei jeweils unterschiedlicher Ausrichtung des Ionenimplantationsbeschusses, unterhalb des Speicherelements ein erster Dotierstoff von einem ersten Leitungstyp eingebracht. Diese Schrägimplantation erfolgt beispielsweise unter einem spitzen Winkel von insbesondere 45° zur Oberseite des Halbleitersubstrats und gelangt somit nicht nur von der Seite schräg bis unterhalb des Speicherelements (Floating-Gate) sondern auch in den übrigen Bereich des Kanals zwischen den Drain- und Source-Anschlussgebieten. Dieser erste Dotierstoff dient der Definition einer vergleichsweise hohen ersten Schwellspannung unterhalb des Speicherelements, wie oben beschrieben. Zur Kompensation dieser hohen ersten Schwellspannung im Bereich des Kanals außerhalb des Speicherelements, also im Bereich des Kanals unterhalb des Steuer-Gates, dient eine Kompensationsimplantation durch einen zweiten (Kompensations-) Dotierstoff von einem zweiten Leitungstyp, der dem ersten Leitungstyp entgegengesetzt ist. Dadurch wird außerhalb des Speicherelements die Implantation des ersten Dotierstoffs teilweise kompensiert und damit neutralisiert. Außerhalb des Speicherelements weist somit der Floating-Gate-Transistor der erfindungsgemäßen Flash-Speicherzelle eine wesentlich niedrigere Schwellspannung auf als unterhalb des Speicherelements. Damit "öffnet" der Steuertransistor (Steuer-Gate) bei niedrigen Spannungen, wie sie beispielsweise zum Lesen der Flash-Speicherzelle eingesetzt werden. Die wegen der dezentralen Anordnung des Speicherelements vergrößerte Kanallänge des Steuertransistors sorgt für reduzierte Leckströme, und zwar auch bei erhöhten Temperaturen.

Zusammenfassend können also die beiden wesentlichen Vorteile der Erfindung hinsichtlich der Verringerung der Auswirkungen der beiden bei Flash-Speicherzellen zu beobachtenden Leckstrommechanismen wie folgt umschrieben werden.

Aufgrund eines insbesondere bei hohen Temperaturen zu großen Ladungsverlusts am Floating Gate (Speichermedium) durch Tunnelströme kann eine Zelle nicht mehr eindeutig ausgelesen werden. Beim Auslesen der Zellen einer Bitleitung darf ein Leckstrom von Source zu Drain, der ungewollt zum Signal- bzw. Auslesestrom beiträgt, möglichst nicht auftreten. Aufgrund der Architektur eines Flash-Speichers weist eine Bitleitung mehrere in Reihe geschaltete Speicherzellen auf, deren Source- und Drain-Anschlüsse wechselweise vertauscht sind. Ist der Leckstrom der unselektierten Zellen einer Bitleitung zu groß, kann eine selektierte und auf "1" programmierte Zelle (Floating Gate sperrt, d. h. kein Stromfluss) nicht mehr mit "1" gelesen werden, obwohl der Ladungszustand nicht kritisch ist.

Die erfindungsgemäße Speicherzelle entschärft den Einfluss des intrinsischen Ladungsverlustes, der durch die Oxiddicke und Qualität festgelegt ist, durch die Anpassung der neutralen Schwelle (neutrale Schwellspannung) des SteuerTransistors an die Leseschwelle bzw. -spannung (Implantationsschema), wodurch der "erlaubte" Ladungsverlust vergrößert wird bzw. der initiale Ladungsunterschied nicht mehr so groß sein muss.

Die erfindungsgemäße Speicherzelle verringert den Einfluss des Leckstroms (Source/Drain) durch die Verlängerung des Steuer-Gates, wodurch das Leckstromniveau gesenkt wird und Zellen auch bei höheren Temperaturen noch eindeutig gelesen werden können.

In weiterer zweckmäßiger Ausgestaltung der Erfindung kann vorgesehen sein, dass das Speicherelement von der Gate-Isolationsschicht höher aufragt als die Steuertransistor-Gate-Elektrode und dass das Speicherelement über seine gesamte Höhe und ggf. darüber hinaus von dem Dielektrikum und der Steuertransistor-Gate-Elektrode umgeben ist.

Zweckmäßig ist es ferner, wenn die Steuertransistor-Gate-Elektrode und insbesondere auch das Speicherelement jeweils polykristallines Silizium aufweist.

Wie bereits oben beschrieben, sollte die Schrägimplantation des ersten Dotierstoffs zur Einbringung desselben in die Oberseite und in den oberseitennahen Bereich des Halbleitersubstrats unterhalb des Speicherelements in mehreren, insbesondere in vier Implantationsschritten erfolgen, wobei der erste Dotierstoff von Implantationsschritt zu Implantationsschritt jeweils in unterschiedlichen, insbesondere gleichmäßig versetzten Raumwinkeln implantiert wird. So ist es beispielsweise bei Einsatz von vier Implantationsschritten möglich, diese in vier um jeweils 90° versetzten Raumwinkelrichtungen unter jeweils 45° zur Oberseite des Halbleitersubstrats einzubringen. Bezogen auf eine Draufsicht auf die Flash-Speicherzelle betrachtet bedeutet dies, dass die vier Implantationsschritte aus Richtung Nord-Ost, aus Richtung Süd-Ost, aus Richtung Süd-West und aus Richtung Nord-West unter jeweils beispielsweise 45° zur Halbleitersubstratoberseite eingeschossen werden.

In weiterer zweckmäßiger Ausgestaltung der Erfindung kann vorgesehen sein, dass das Speicherelement und zumindest die zweite Gate-Isolationsschicht von einem Gate-Elektrodenmaterial überdeckt wird und dass das Gate-Elektrodenmaterial bis in Höhe der Oberseite des aufragenden Speicherelements oder oberhalb dessen heruntergeätzt wird, wobei durch Maskierung des größeren der beiden Abstandsbereiche des Speicherelements zu den Drain- und Source-Anschlussgebieten, der sich zwischen dem Speicherelement und dem Drain-Anschlussgebiet erstreckt, Gate-Elektrodenmaterial zur Erzeugung eines Kanalgebiets auf der Oberseite des Halbleitersubstrats mit einer Länge gebildet wird, die durch den Abstand des Speicherelements zum Drain-Anschlussgebiet definiert ist.

Die Erfindung wird nachfolgend anhand eines Ausführungsbeispiels und unter Bezugnahme auf die Zeichnung näher erläutert. Im Einzelnen zeigen dabei:
- Fig. 1: eine prinzipielle Darstellung eines Ausführungsbeispiels einer erfindungsgemäßen Flash-Speicherzelle bestehend aus Speichertransistor (Floating-Gate) und Steuertransistor (Sidewall-Transistor bzw. Steuer-Gate),
- Fign. 2 bis 21: Darstellungen des nach und nach in mehreren Verfahrensschritten hergestellten Floating-Gate-Transistors der erfindungsgemäßen Flash-Speicherzelle und
- Fign. 22 bis 25: schematische Darstellungen zur Verdeutlichung der Besonderheiten der Flash-Speicherzelle zur Unterdrückung von Leckströmen.

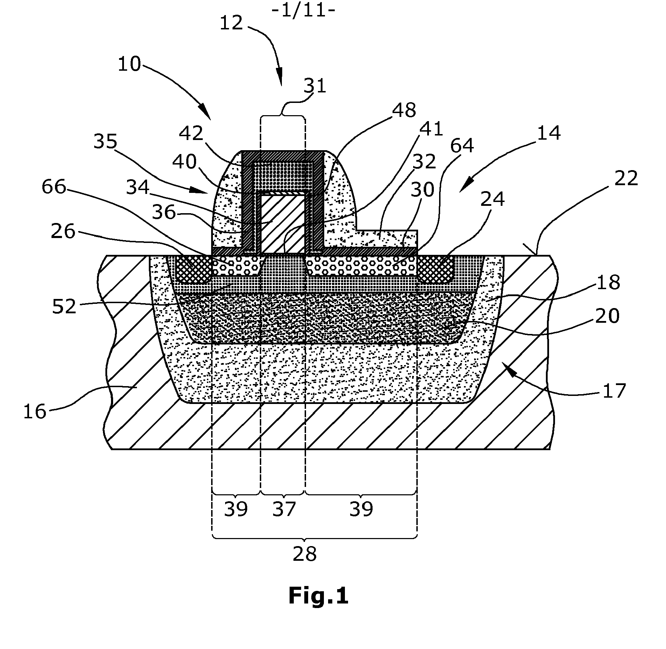

Fig. 1 zeigt den Aufbau einer Flash-Speicherzelle 10 gemäß einem Ausführungsbeispiel der Erfindung, die als Floating-Gate-Transistoranordnung ausgebildet ist. Die Flash-Speicherzelle 10 weist einen Speichertransistor 12 mit dem Floating-Gate als Speicherelement und einen Sidewall- bzw. Steuertransistor 14 mit einem an sich üblichen Steuer-Gate auf.

In einem p-Substrat 16 ist eine Doppelwannenstruktur 17 aus einer ersten tiefen n-Wanne 18 und einer zweiten flachen p-Wanne 20 ausgebildet. Das Halbleitersubstrat 16 weist eine Oberseite 22 auf, auf bzw. in der die Floating-Gate-Transistoranordnung ausgebildet ist. Zu diesem Zweck sind in die p-Wanne 20 ein Drain-Anschlussgebiet 24 und ein Source-Anschlussgebiet 26 eingebracht. Zwischen diesen beiden Anschlussgebieten 24,26 erstreckt sich das Kanalgebiet 28. Ferner befindet sich auf der Oberseite 22 des Halbleitersubstrats 16 eine Gate-Isolationsschicht 30, auf der wiederum die Gate-Elektrode 32 des Steuertransistors 14 angeordnet ist. Ferner befindet sich auf der Gate-Isolationsschicht 30 ein von dieser aufragendes Speicherelement 34 aus einem elektrisch aufladbaren bzw. elektrisch entladbaren Speichermaterial, das das Floating-Gate bildet. Das Speicherelement 34 ist bei 35 von dem Material der Gate-Elektrode 32 des Steuertransistors 14 umgeben, ist aber gegenüber dieser Steuertransistor-Gate-Elektrode 32 durch ein Dielektrikum 36 elektrisch isoliert. Mit anderen Worten sind das Speicherelement 34 und die Gate-Elektrode 32 des Steuertransistors 14 kapazitiv gekoppelt.

Wie anhand von Fig. 1 zu erkennen ist, befindet sich das Speicherelement 34 dezentral zwischen dem Source- und dem Drain-Anschlussgebiet 26 bzw. 24. Der unterhalb des Speicherelements 34 befindliche Kanalbereich 37 des Kanalgebietes 28 ist in Abhängigkeit vom Ladungszustand des Speicherelements 34 unterbrochen oder leitend, was sich bei Anlegen der Auslesespannung dadurch zeigt, dass ein Strom fließt (erste binäre Information) oder nicht (zweite binäre Information). Das Kanalgebiet 39 im Bereich unterhalb der Gate-Elektrode 32 wird durch deren Gate-Spannung kontrolliert.

Wie ferner anhand von Fig. 1 zu erkennen ist, ist die Gate-Isolationsschicht 30 im Bereich 31 unterhalb des Speicherelements 34 dünner als unterhalb der Gate-Elektrode 32 des Steuertransistors 14.

Die Gate-Isolationsschicht 30 wirkt in ihrem Bereich 31, d.h. auf dem Kanalbereich 37 unterhalb des Speicherelements 34 als eine Tunnel-Isolationsschicht, durch die hindurch auf Grund des Tunneleffekts Ladungen in das Speicherelement 34 eingebracht werden können. Dieser Auf- und Entlade-Mechanismus ist im Zusammenhang mit Floating-Gate-Transistoren und damit im Zusammenhang mit Flash-Speicherzellen grundsätzlich bekannt und soll hier nicht weiter erläutert werden.

Als eine der Besonderheiten der Flash-Speicherzelle 10 kann die dezentrale Anordnung des Speicherelements 34 angesehen werden. Durch diese dezentrale Anordnung wird die wirksame Kanallänge des Steuertransistors 14 vergrößert, was dazu beiträgt, dass sich in denjenigen Zellen einer Bitleitung des Flashspeichers, die beim Anlegen der Lesespannung zwischen Drain und Source sperren sollen, die Entstehung von Leckströmen verringert..

Als weitere Besonderheit kann angesehen werden, dass innerhalb des Kanalgebiets 28 die Schwellspannung unterhalb des Speicherelements 34, also im Kanalbereich 37 wesentlich höher ist als unterhalb der Steuertransistor-Gate-Elektrode 32, d.h. in den Kanalbereichen 39. Durch diese unterschiedlich eingestellten Schwellspannungen lässt sich das Langzeit-Speicherverhalten der Flash-Speicherzelle 10 positiv beeinflussen, da nämlich mit vergleichsweise geringen gespeicherten Ladungen im Speicherelement 34 gearbeitet werden kann, um binäre Ladungszustände mit ausreichender Zuverlässigkeit voneinander unterscheidbar zu gestalten. Damit bleibt die Ladung in dem Speicherelement 34 über längere Zeit erhalten, und zwar auch dann, wenn die Flash-Speicherzelle 10 erhöhten Umgebungstemperaturen ausgesetzt ist. Dies wird nachfolgend kurz erläutert.

Grundsätzlich ist es so, dass die Ladung des Speicherelements 34 die Schwellspannung der gesamten Floating-Gate-Transistoranordnung bestimmt. Die Entladecharakteristik des Speicherelements 34 ist, über die Zeit betrachtet, exponentiell abfallend. Das bedeutet, dass die Entladungsrate mit zunehmender Zeit abnimmt. Wenn es nun gelingt, die beiden Zustände "GELÖSCHT" und "PROGRAMMIERT" durch Einbringung einer vergleichsweise geringen Ladungsmenge in das Speicherelement 34 voneinander unterscheiden zu können, bleibt diese sichere Unterscheidung auch über längere Zeit erhalten, d.h. bleibt die gespeicherte Information über längere Zeit erhalten, da sich ja der Ladungszustand des Speicherelements 34 nur noch geringfügig ändert. Damit nun mit vergleichsweise geringen elektrischen Ladungen gearbeitet werden kann, sollte der Auslesearbeitspunkt der Flash-Speicherzelle 10 möglichst in der Mitte zwischen den beiden Strom-Spannungs-Kurven für die Zustände "GELÖSCHT" und "PROGRAMMIERT" liegen. Dies gelingt durch entsprechende Einstellung der Schwellspannung unterhalb des Speicherelements 34.

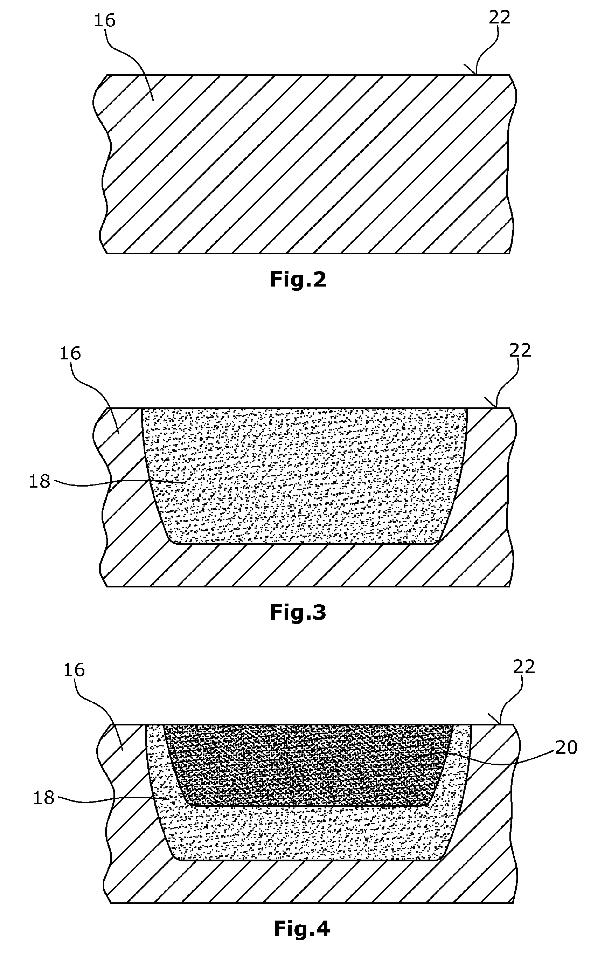

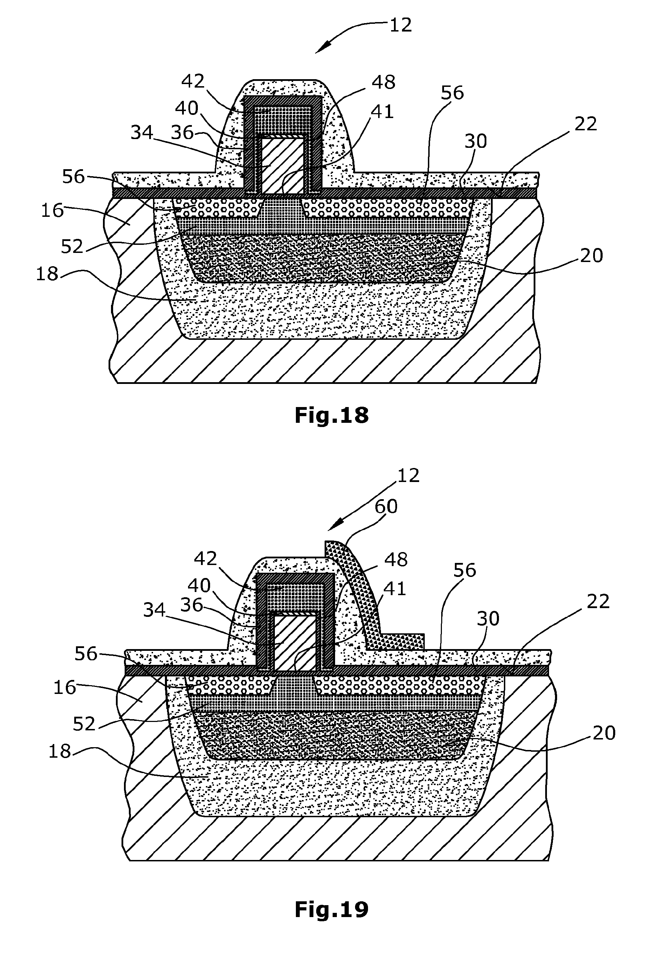

Anhand der Fign. 2 bis 21 soll nachfolgend auf ein Beispiel eines Herstellungsprozesses zur Herstellung der Flash-Speicherzelle 10 eingegangen werden.

Ausgehend von der Situation gemäß Fig. 2 wird in das p-Halbleitersubstrat 16 die n-Wanne 18 eingebracht (siehe Fig. 3). Anschließend wird dann in die n-Wanne 18 die p-Wanne 20 eingebracht (siehe Fig. 4).

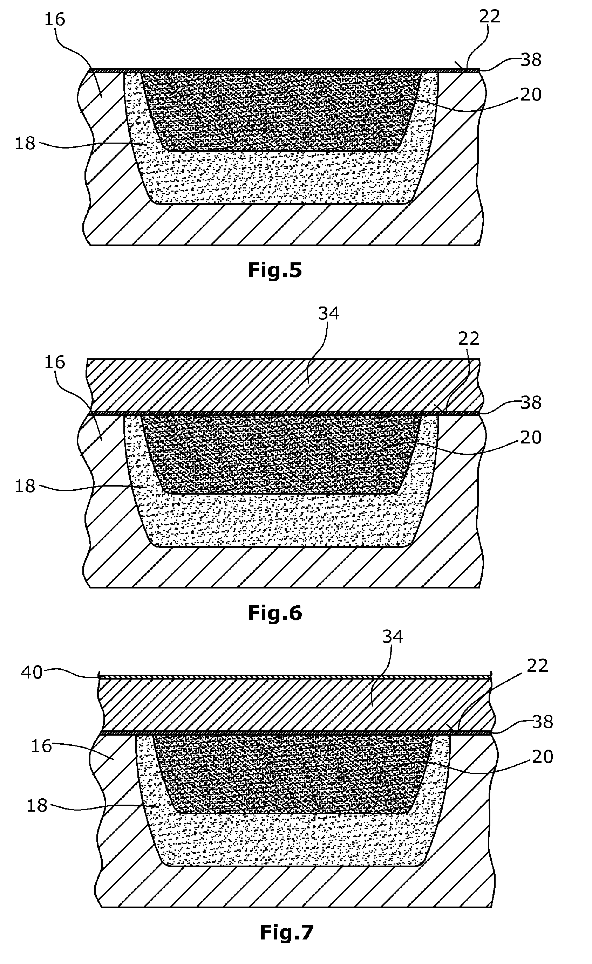

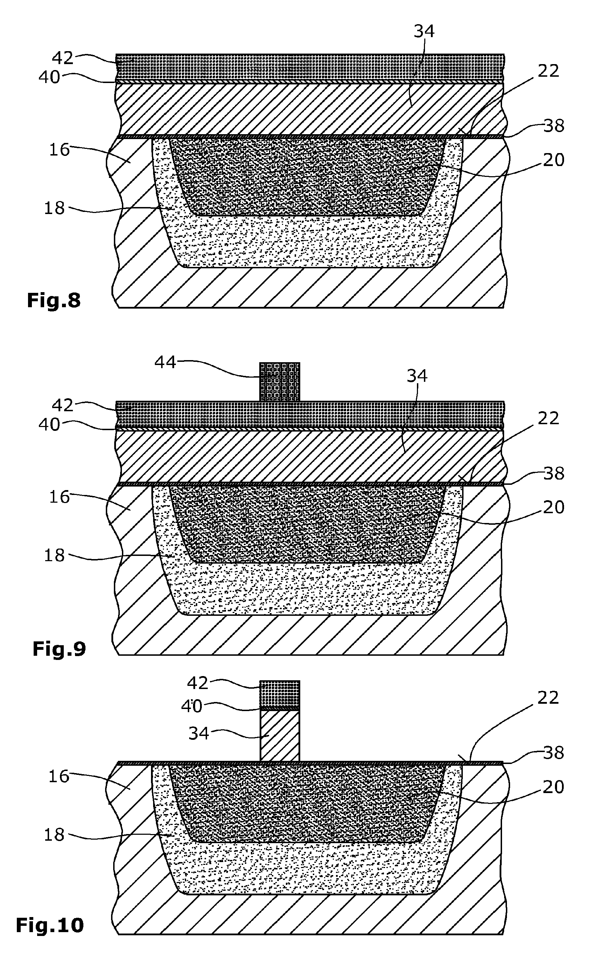

In einem nächsten Prozessschritt wird das Tunnel-Isolationsmaterial, das sich im Bereich 38 der Gate-Isolationsschicht 30 befindet (siehe Fig. 1), erzeugt, und zwar auf der Oberseite 22 des Halbleitersubstrats 16. Auf dieses Tunnel-Isolationsmaterial wird dann das Speichermaterial (in diesem Fall polykristallines Silizium) für das Speicherelement 34 aufgebracht, woraufhin dann auf dieses Speichermaterial ein weiteres Dielektrikum 40 mit einer Hartmaske 42 beispielsweise aus Nitrid aufgebracht wird. Dies ist in den Fign. 5 bis 8 gezeigt. Auf die Nitrid-Hartmaskenschicht 42 wird dann ein Photolack 44 aufgebracht, der strukturiert ist, so dass er lediglich noch im Bereich oberhalb des späteren Speicherelements 34 verbleibt (siehe Fig. 9).

Anschließend wird, wie in Fig. 10 gezeigt, ein Ätzprozess durchgeführt, so dass lediglich noch das Speichermaterial für das Speicherelement 34 verbleibt, das durch das weitere Dielektrikum 40 und die Nitrid-Hartmaskenschicht 42 abgedeckt ist.

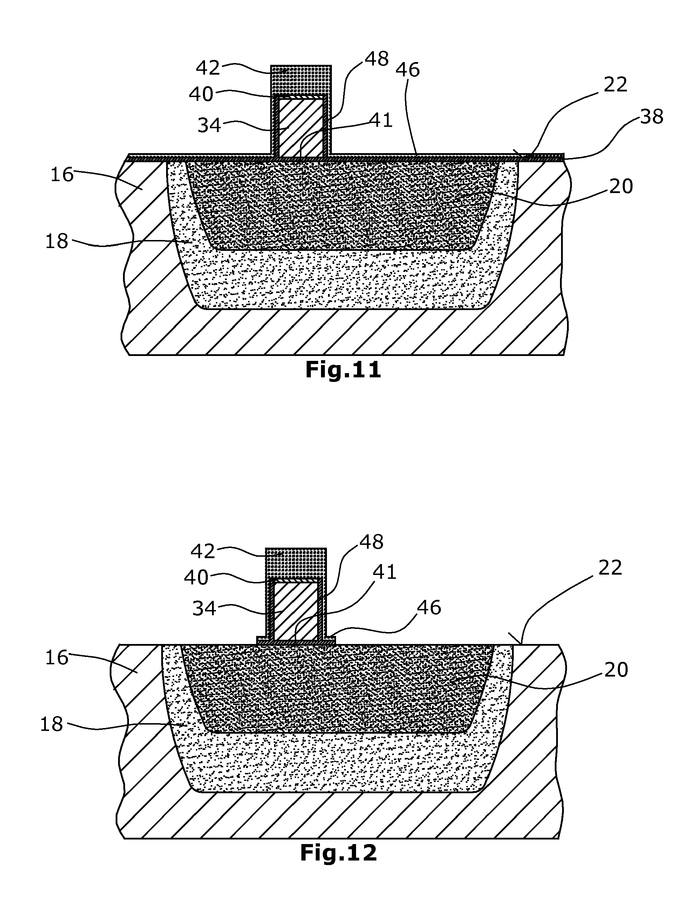

In einem nächsten Prozessschritt (siehe Fig. 11) wird das Tunnel-Isolationsmaterial 38 durch Silizium-Nitrid oder ein anderes Hartmaskenmaterial 46 abgedeckt. Dieses Material 46 legt sich auch an den Außenseiten des aufragenden Speicherelements 34 an, und zwar genauso wie zuvor das Material der Gate-Isolationsschicht 30 (siehe dazu auch Fig. 11 bei 48).

Dann wird die Doppelschicht aus dem Tunnel-Isolationsmaterial 38 und dem Hartmaskenmaterial 46 von der Oberseite 22 des Halbleitersubstrats 16 entfernt (siehe Fig. 12).

Nach diesen Prozessschritten ist also das Speicherelement 34 allseitig von Dielektrikum-Material (nämlich 40, 48) umgeben.

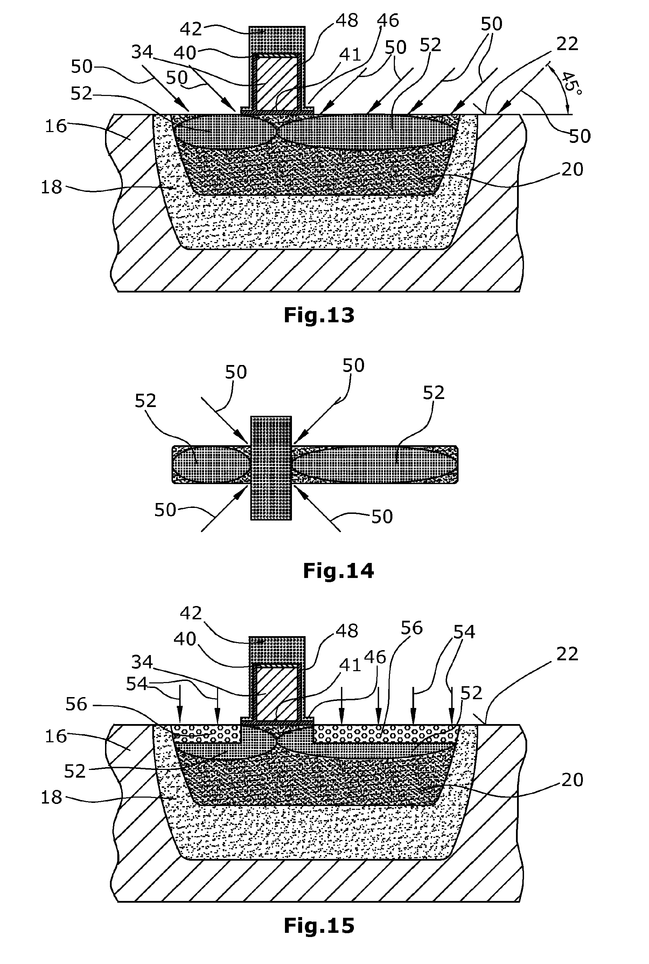

In den Fign. 13 und 14 ist gezeigt, wie zwecks Einstellung der Schwellspannung unterhalb des Speicherelements 34 in die Oberseite 22 des Halbleitersubstrats 16 mehrere Schrägimplantationen 50 von p-Dotierstoff (beispielsweise Bor) eingebracht wird. Die Pfeile zeigen die Neigung der Schrägimplantationen 50 gegenüber der Oberseite 22 des Halbleitersubstrats 16 (in diesem Ausführungsbeispiel 45°). In Fig. 14 ist gezeigt, dass letztendlich die Schrägimplantationen 50 aus vier paarweise jeweils gegenüberliegenden Richtungen in die Oberseite 22 und damit auch bis unterhalb des Speicherelements 34 eingebracht werden.

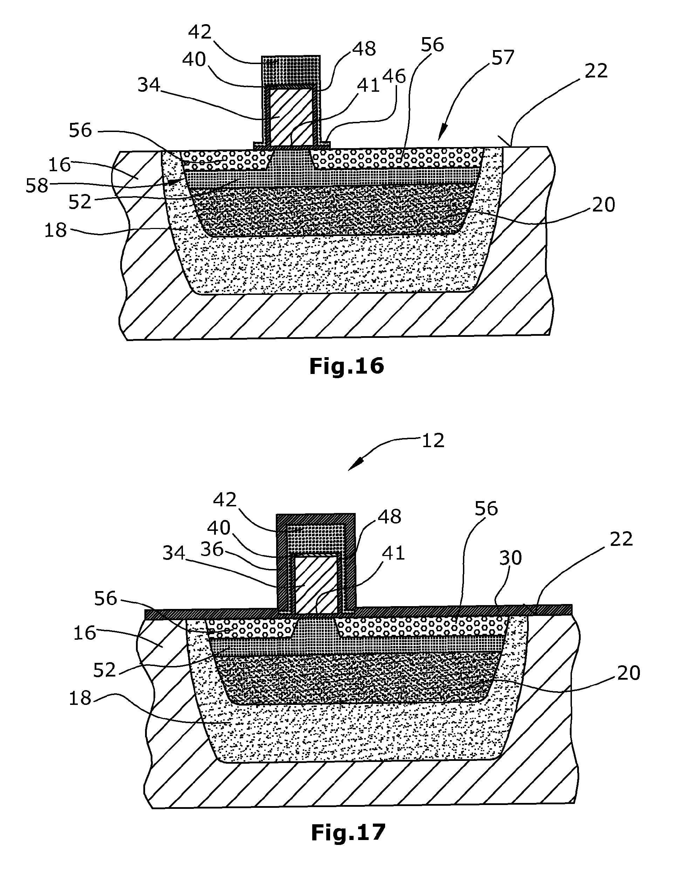

Durch die Schrägimplantationen des p-Dotierstoffs 52 wird selbstverständlich auch die Schwellspannung außerhalb des Speicherelements 34 beeinflusst. Außerhalb des Speicherelements 34 befindet sich aber der eigentliche Steuertransistor 14, der eine niedrigere Schwellspannung als die Schwellspannung unterhalb des Speicherelements 34 aufweisen sollte. Daher wird, wie in Fig. 15 gezeigt, durch eine weitere Implantation 54 eines zweiten n-Dotierstoffs 56 die Dotierung mit dem ersten Dotierstoff 52 außerhalb des Speicherelements 34 kompensiert. Nach thermischer Aktivierung beider Implantationen 50,54 stellt sich die Situation gemäß Fig. 16 ein. In der oberflächennahen Zone 57 ist die Dotierstoff-Konzentration geringer als in der in vertikaler Richtung benachbarten Zone 58. In vertikaler Richtung betrachtet folgt auf diese Zone 58 der untere Teil der p-Wanne 20. Zu erkennen ist, dass die Zone 58, die gegenüber der Zone 57 eine höhere p-Dotierstoff-Konzentration aufweist, sich auch bis unterhalb des Speicherelements 34 erstreckt und damit die Schwellspannung des Speichertransistors 12 bestimmt.

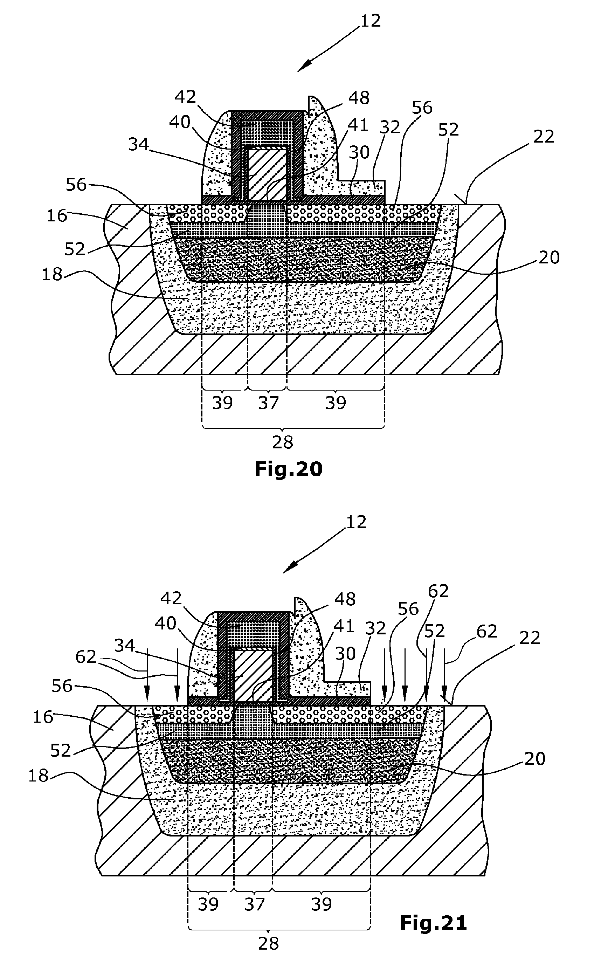

Die nächsten Verfahrensschritte zur Herstellung der Flash-Speicherzelle 10 sind in den Fign. 17 bis 19 gezeigt. Hier geht es um das Aufbringen des Oxids als Gate-Isolationsschicht 30 beidseitig des Speicherelements 34 (siehe Fig. 17), um das Aufbringen einer Schicht aus Elektrodenmaterial (beispielsweise polykristallines Silizium) für die spätere Gate-Elektrode 32 des Steuertransistors 14, wobei infolge der an sich bekannten Spacer-Herstellung sich nun auch allseitig um das aufragende Speicherelement 34 herum dieses Elektrodenmaterial befindet, und schließlich um die Aufbringung einer Photolackschicht 60, die dann strukturiert wird, damit sich nach dem Herunterätzen der Elektrodenmaterialschicht die Situation gemäß Fig. 20 einstellt. In Fig. 20 ist zu erkennen, dass das Elektrodenmaterial für die Gate-Elektrode 32 des Steuertransistors 14 auf Grund der strukturierten Photolackschicht 60 asymmetrisch stehen bleibt. Es entsteht der vergleichsweise lange Kanalbereich 39 des Steuertransistors 14. Schließlich werden beidseitig der Steuertransistor-Gate-Elektrode 32 in die p-Wanne die Implantationen 62 zur Herstellung der späteren Drain- und Source-Anschlussgebiete 24,26 eingebracht, die in niedriger dotierten Umgebungsgebieten 64,66 angeordnet sein können (siehe Fig. 21).

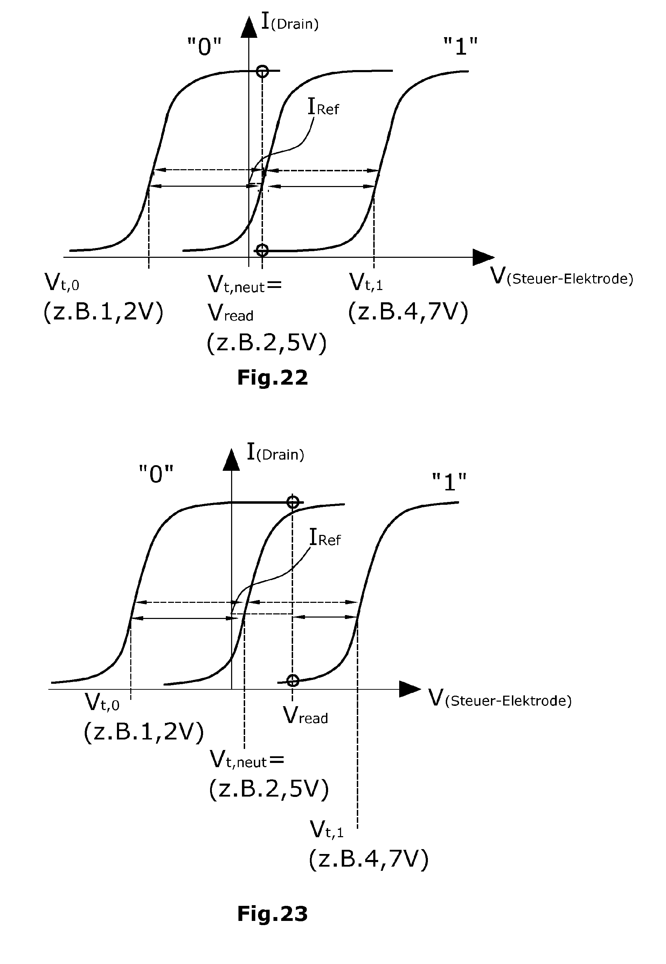

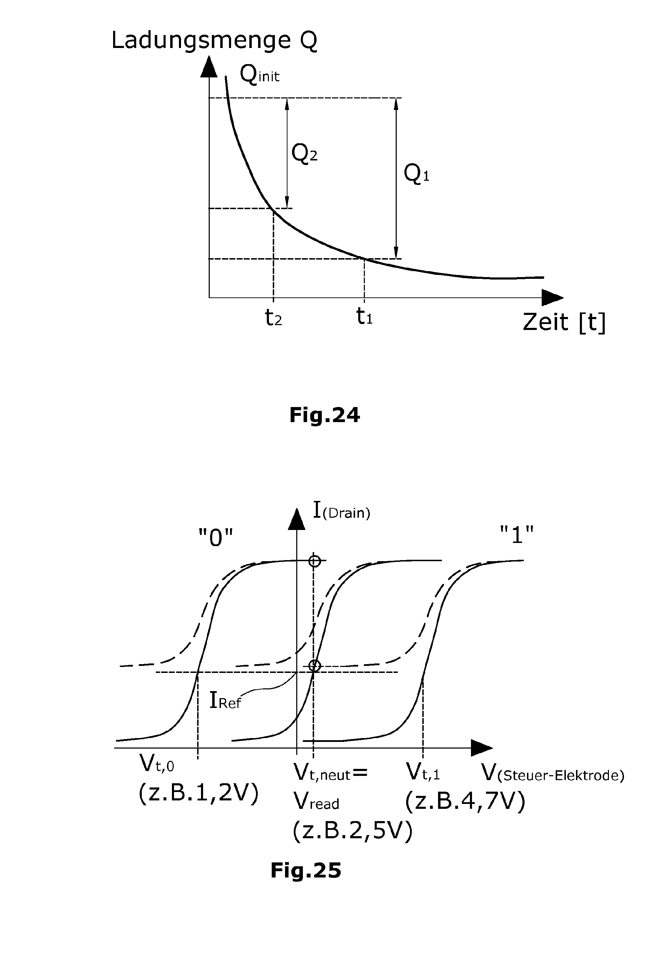

Anhand der Fign. 22 bis 25 wird nochmals kurz auf die beiden wesentlichen Verbesserungen der Speicherzelle eingegangen. Dabei sei angenommen, dass die Speicherzelle die binäre Information "O" speichert (mit der Schwellspannung V_{t,0} z. B. 1,2 V - die eigentlich "0" Schwelle liegt bei ca. 0,3V, wird aber durch die Schwelle des Steuertransistors, der später aufmacht, maskiert), wenn ihr Speicherelement 34 positiv geladen ist und dementsprechend die andere binäre Information "1" speichert (mit der Schwellspannung Vₜ, ₁ z. B. 4,7 V), wenn ihr Speicherelement negativ geladen ist. Wird nun, wie bei der Erfindung, die neutrale Schwelle V_{t,neut} so eingestellt (nämlich durch entsprechendes Einbringen einer Dotierstoffkonzentration im Kanalgebiet unterhalb des Speicherelements 34), dass sie bei der Auslesespannung (von z. B. 2,5 V) liegt, so ist die neutrale Schwelle (z. B. 1,2 V) immer symmetrisch zwischen "0" und "1" und die Differenz der Ladungsmenge Qᵢₙᵢₜ (siehe Fig. 24) ist gegenüber "neutral" (gestrichelte Pfeile in Fig. 22) gleich groß. Die Auslesung erfolgt durch Vergleich des Zellstroms (Kreise in Fig. 22) bei V_{read} gegenüber einem Referenzstrom I_{Ref}.

Wenn der Auslesearbeitspunkt V_{read} gleich V_{t,neut} ist (siehe Fig. 22), dann ist der maximale erlaubte Ladungsverlust Q₁, bei dem der Zellzustand noch eindeutig bestimmt werden kann, gegenüber V_{read} symmetrisch (durchgezogene Pfeile in Fig. 22). Damit stellt sich der erst recht spät erreichbare Entladungszeitpunkt t₁ ein (siehe Fig. 24).

Ist V_{read} ungleich V_{t,neut} (siehe Fig. 23) ist der maximal erlaubte Ladungsverlust Q₂ für einen der beiden Zustände geringer als beim symmetrischen Fenster nach Fig. 22. Damit arbeitet die Zelle lediglich bis zum bereits früher als t₁ erreichten Entladungszeitpunkt t₂ korrekt.

Bekannte Kurzkanal-Zellen weisen bei Temperaturen größer 80°C die in Fig. 25 gestrichelt dargestellte Strom-Spannungs(I-V-)Charakteristik auf. Die Zellen mit "0" und "1" Zustand weisen einen Leckstrom auf, der oberhalb des Vergleichsstroms I_{Ref} liegt, d. h. beide Zellen mit "0" und "1" würden als "0" gelesen. Der hohe Leckstrom ist auf Kurzkanaleffekte zurückzuführen. Durch die Verlängerung des Steuer-Gates nach der Erfindung werden die Kurzkanaleffekte vermindert (durchgezogene Kennlinien in Fig. 25). Auch bei Temperaturen um 150° ist noch ein vertretbar geringer Leckstrom vorhanden und "1" programmierte Zellen können als "1" gelesen werden.

### BEZUGSZEICHENLISTE

- 10: Flash-Speicherzelle
- 12: Speichertransistor der Flash-Speicherzelle
- 14: Steuertransistor der Flash-Speicherzelle
- 16: Halbleitersubstrat
- 18: Doppelwannenstruktur im Halbleitersubstrat
- 22: Oberseite des Halbleitersubstrats
- 24: Drain-Anschlussgebiet
- 26: Source-Anschlussgebiet
- 28: Kanalgebiet
- 30: Gate-Isolationsschicht
- 31: Gate-Isolationsschichtbereich unterhalb des Speicherelements
- 32: Steuertransistor-Gate-Elektrode
- 34: Speicherelement
- 35: Material der Gate-Elektrode um Speicherelement herum
- 36: Dielektrikum
- 37: Kanalbereich unterhalb des Speicherelements
- 38: Tunnel-Isolationsmaterial unterhalb des Speicherelements
- 39: Steuerkanal des Steuertransistors
- 40: Dielektrikum
- 42: Nitrid-Hartmaskenschicht
- 44: Photolack
- 46: Hartmaskenmaterial
- 48: Dielektrikum
- 50: Schrägimplantation zur Einstellung der Schwellspannung unterhalb des Speicherelements
- 52: erster Dotierstoff
- 54: Implantation zur Einstellung der Schwellspannung unterhalb der Steuertransistor-Gate-Elektrode
- 56: (zweiter) Kompensationsdotierstoff
- 57: oberflächennahe Zone des Halbleitersubstrats
- 58: benachbarte Zone zur oberflächennahen Zone
- 60: Photolackschicht
- 62: Implantationen für Drain und Source
- 64: Umgebungsgebiet um Drain
- 66: Umgebungsgebiet um Source

## Patentansprüche

1. Flash-Speicherzelle, die durch Anlegen von Programmier- und Löschspannungen beschreibbar sowie löschbar und durch Anlegen einer Lesespannung auslesbar ist, mit
- einem Halbleitersubstrat (16), das eine Oberseite (22) aufweist,
- in die Oberseite (22) des Halbleitersubstrats (16) eingebrachten, voneinander beabstandeten Drain- und Source-Anschlussgebieten (24,26),
- einer Gate-Isolationsschicht, die auf der Oberseite (22) des Halbleitersubstrats (16) zwischen dem Drain- und dem Source-Anschlussgebiet (24,26) angeordnet ist,
- einem von der Gate-Isolationsschicht (30) aufragenden Speicherelement (34) aus einem Speichermaterial für elektrische Ladung, die durch Erzeugen eines Tunnelstroms durch den unterhalb des Speicherelements (34) angeordneten Bereich (38) der Gate-Isolationsschicht (30) hindurch elektrisch auf- und entladbar ist,
- wobei das Speicherelement (34) dezentral zwischen den Drain- und Source-Anschlussgebieten (24,26) und mit jeweiligem lateralen Abstand zu beiden positioniert ist, und
- einer die Gate-Isolationsschicht (30) überdeckenden, das Speicherelement (34) allseitig umgebenden sowie gegenüber diesem durch ein Dielektrikum (44,48) elektrisch isolierten Steuertransistor-Gate-Elektrode (32) zur Erzeugung eines wahlweise elektrisch leitenden oder sperrenden Kanals unterhalb der Steuertransistor-Gate-Elektrode (32),
- wobei die Oberseite (22) des Halbleitersubstrats (16) unterhalb der Gate-Isolationsschicht (30) in einem Bereich zwischen dem Drain- und dem Source-Anschlussgebiet (24,26) ein laterales Dotierstoffprofil aufweist, das im Bereich unterhalb des Speicherelements (34) zur Einstellung einer relativ hohen ersten Schwellspannung einen Dotierstoff von einem ersten Leitungstyp und im Bereich unterhalb der Steuertransistor-Gate-Elektrode (32) zur Einstellung einer im Vergleich zur ersten Schwellspannung wesentlich geringeren zweiten Schwellspannung den ersten Dotierstoff (52) und einen zweiten Kompensationsdotierstoff (56) von einem zum ersten Leitungstyp entgegengesetzten zweiten Leitungstyp aufweist.

2. Flash-Speicherzelle nach Anspruch 1, **dadurch gekennzeichnet, dass** die Gate-Isolationsschicht (30) in ihrem Bereich unterhalb des Speicherelements (34) dünner ist als in ihrem Bereich unterhalb der Steuertransistor-Gate-Elektrode (32).

3. Flash-Speicherzelle nach einem der Ansprüche 1 oder 2, **dadurch gekennzeichnet, dass** das Speicherelement (34) von der Gate-Isolationsschicht (30) höher aufragt als die Steuertransistor-Gate-Elektrode (32) und dass das Speicherelement (34) über seine gesamte Höhe und ggf. darüber hinaus von dem Dielektrikum (44,48) und der Steuertransistor-Gate-Elektrode (32) umgeben ist.

4. Flash-Speicherzelle nach Anspruch 3, **dadurch gekennzeichnet, dass** die Steuertransistor-Gate-Elektrode (32) polykristallines Silizium aufweist.

5. Flash-Speicherzelle nach einem oder mehreren der Ansprüche 1 bis 4, **dadurch gekennzeichnet, dass** das Speicherelement (34) polykristallines Silizium aufweist.

6. Verfahren zur Herstellung einer Flash-Zelle, insbesondere nach einem der vorstehenden Ansprüche, bei dem
- ein Halbleitersubstrat (16) mit einer Oberseite (22) bereitgestellt wird, in die ein Drain- und ein Source-Anschlussgebiet (24,26) eingebracht sind und auf der in einem dezentral und im Abstand zu den Drain- und Source-Gebieten (24,26) gelegenen Teilbereich zwischen dem Drain- und dem Source-Anschlussgebiet (24,26) eine erste Gate-Isolationsschicht (30) aufgebracht ist, von der ein Speicherelement (34) aus Speichermaterial für elektrische Ladung aufragt,
- im spitzen Winkel von einer Seite oder allseitig des Speicherelements (34) aus in die Oberfläche des Halbleitersubstrats (16) und damit auch schräg unterhalb des Speicherelements (34) erste Ionen zum örtlichen Dotieren des Halbleitersubstrats (16) mit einem ersten Dotierstoff (52) eines ersten Leitungstyps zwecks Einstellung einer relativ hohen ersten Schwellspannung im Bereich unter dem Speicherelement (34) implantiert werden,
- in den Bereich der Oberfläche des Halbleitersubstrats (16) zwischen den Drain- und Source-Anschlussgebieten (24,26) sowie außerhalb des Speicherelements (34) zur Kompensation der dort implantierten ersten Ionen zweite Ionen zur örtlichen Kompensationsdotierung mit einem zweiten Dotierstoff (56) von einem dem ersten Leitungstyp entgegengesetzten zweiten Leitungstyp zwecks Einstellen einer gegenüber der ersten Schwellspannung wesentlich geringeren zweiten Schwellspannung im Bereich außerhalb des Speicherelements (34) implantiert werden und
- eine zweite Gate-Isolationsschicht (30) lateral zur ersten Gate-Isolationsschicht (30) auf der Oberseite (22) des Halbleitersubstrats (16) zwischen den Drain- und Source-Anschlussgebieten (24,26) mit einer das Speicherelement (34) allseitig umgebenden und gegebenenfalls dieses überdeckenden Steuertransistor-Gate-Elektrode (32) ausgebildet wird.

7. Verfahren nach Anspruch 6, **dadurch gekennzeichnet, dass** die Schrägimplantation in mehreren, insbesondere vier Implantationsschritten erfolgt, wobei der erste Dotierstoff (52) von Implantationsschritt zu Implantationsschritt jeweils in unterschiedlichen, insbesondere gleichmäßig versetzten Randwinkeln implantiert wird.

8. Verfahren nach Anspruch 6, **dadurch gekennzeichnet, dass** das Speicherelement (34) und zumindest die zweite Gate-Isolationsschicht (30) von einem Gate-Elektrodenmaterial überdeckt wird und dass das Gate-Elektrodenmaterial bis in Höhe der Oberseite (22) des aufragenden Speicherelements (34) oder oberhalb dessen heruntergeätzt wird, wobei durch Maskierung des größeren der beiden Abstandsbereiche des Speicherelements (34) zu den Drain- und Source-Anschlussgebieten (24,26) Gate-Elektrodenmaterial zur Erzeugung eines Kanalgebiets auf der Oberseite (22) des Halbleitersubstrats (16) mit einer Länge gebildet wird, die durch den längeren der beiden Abstandsbereiche definiert ist.
